# EUROPEAN PATENT SPECIFICATION

(11) **EP 0 473 418 B1**
(45) Date of publication and mention of the grant of the patent: **22.10.1997**
(21) Application number: 91307886.1
(22) Date of filing: 28.08.1991
(51) Int. Cl.: H05K 7/14, H01R 13/62

(54) **Connector apparatus for IC packages**
Steckervorrichtung für IC-Gehäuse
Appareil connecteur pour encapsulages de circuits intégrés

(30) Priority: 31.08.1990 JP 90772/90
(43) Date of publication of application: 04.03.1992
(60) Divisional application: 97105523.1
(73) Proprietor: E.I. DU PONT DE NEMOURS AND COMPANY, Wilmington Delaware 19898 (US); BERG ELECTRONICS MANUFACTURING B.V., 5222 AV s'-Hertogenbosch (NL); CONNECTOR SYSTEMS TECHNOLOGY N.V., Willemstad, Curaçao (AN)
(72) Inventor: Abe, Hiroshi, Midori-ku, Yokohama-shi (JP); Narita, Hiroshi, Meguro-ku, Tokyo (JP); Takahashi, Ryosuke, Miyamae-ku, Kawasaki-shi (JP)
(74) Representative: Barnard, Eric Edward

(56) References cited:
- EP-A- 0 293 215
- EP-A- 0 385 750
- FR-A- 2 259 510
- US-A- 4 810 200
- US-A- 4 952 161

## Description

This invention relates to a connector apparatus for plate-like IC packages, more particularly, to a connector apparatus for receiving and ejecting a memory card which is connected to CPU, DMA, or the like, in a electronic device for reading out data stored in the package to perform predetermined tasks.

In an electronic device, such as a microcomputer, it has been common practice to mount an IC package, such as a memory card, in an electronic device body, if necessary, in an electrically connected fashion so as to accomplish, for example, an extended application. For this purpose, a connector apparatus has been used in the art.

The conventional connector apparatus for an IC package is of such a type that it has a substantially U-shaped frame with a pair of guide grooves provided on its inner side frame portions and a connector section provided as a connection frame portion between the side frame portions and, in use, a plate-like IC package is inserted via an access hole into the device space, while being guided along the guide grooves, and held there with its array of socket terminals electrically connected to an associated pin terminal array of the connector section.

In the connector apparatus as set out above, an ejecting mechanism can be provided which, when the package is not in use, electrically disconnects the package.

EP-A-0293215 discloses a connection apparatus for printed circuit boards having ejecting mechanisms. Each ejecting mechanism is so operated that a lever is rotated around a fulcrum to cause an engaging hook means which is provided on the forward end of a plate-like member to engage with the forward end edge of a circuit board whereby it is possible to eject the board out of a storage site.

US-A- 4810200 also describes connector apparatus for an IC package of this type in which a package is inserted between a pair of spaced-apart guides joined to a base member and pushed until a locking lever at one side engages with a notch in the package. After release of the locking lever, the package can be ejected by operating an ejecting lever pivoted to the base to cause a plate member which slides over the base to engage with the package.

EP-A-0 385 750 and US-A-4 952 161 also describe connector apparatus for IC packages.

In a recent trend toward thin, lightweight compact electronic devices, there is a demand for a corresponding compact connector which receives an IC package into its storage space and holds the package electrically connected with the electronic device.

In the known types of connector apparatus for IC packages, in order to prevent deformation due to loading the lever has to be relatively thick and, further, a strong structure needs to be provided at the fulcrum site. It is thus not possible to make the connector thinner in the direction of the thickness of the package and the connector is not particularly compact.

It is accordingly an object of the present invention to provide a connector apparatus for plate-like IC packages, which takes the form of a thin, lightweight compact unit, closely equal to the dimensions of the package per se and which is very durable in spite of its thin structure.

As is known from US-A-4 810 200 a connector apparatus constructed in accordance with the invention comprises a connector apparatus for use with plate-like IC packages, said apparatus comprising:
a pair of guide frame members spaced apart to correspond to the width of a plate-like IC package;
a housing plate member fixing said guide frame members in place;
a connector section having connecting pins to be electrically connected to said package, provided at one end of the guide frame members;
a pull-out plate member displaceable over a surface of the housing plate member and having engaging means engageable with a forward end of said package electrically connected to the connector section and
an ejection lever pivotably mounted to the housing plate member with a journal structure and coupled to the pull-out plate, the lever being operable to cause the pull-out plate member to be displaced to eject the package.

In accordance with the invention the journal structure is composed of a shaft fitted inside a tubular projection, wherein the journal structure is composed of a shaft fitted inside a tubular projection formed as part of said ejection lever or of said housing plate member respectively the projection being inserted through a bearing hole formed in said housing plate member or said ejection lever respectively, and slippage preventing means provided at each end of the shaft to maintain the lever on the housing plate member.

When the ejection lever is pivoted about the journal structure, the lever coupled at one end to the pull-out plate is slidably moved over the surface of the housing plate member. When this occurs, the package is ejected through the engagement of the pull-out plate with the front end of the IC package to cause the IC package to be electrically disconnected from the connector section.

To actuate the lever, the apparatus may have an actuation or slide member slidably movable in a guide at the outer side of one of the guide frame members and the slide member is pivotably coupled with another journal structure to one end of the ejection lever. Preferably, the journal structure pivotably coupling the lever to the slide member is formed in a similar manner to the journal structure pivotably mounting the lever to the housing plate member.

To further guide the lever, the lever may have a tongue at the other end which locates in slidable contact with a guide on the housing plate member.

To provide electrical shielding it is desirable for the pull-out plate to have appropriate projections which engage through holes in the housing plate to contact the package.

The connector section can be detachably connected to the structure composed of the guide members and the housing plate member.

This invention can be more fully understood from the following detailed description taken in conjunction with the accompanying drawings, in which:
Fig. 1 is a plan view showing one embodiment of the present invention;
Fig. 2 is a bottom view showing the embodiment of the present invention;
Fig. 3 is a cross-sectional view showing a journal support structure of an ejection lever in the embodiment of the present invention; and
Fig. 4 is a side view showing the embodiment of the present invention.

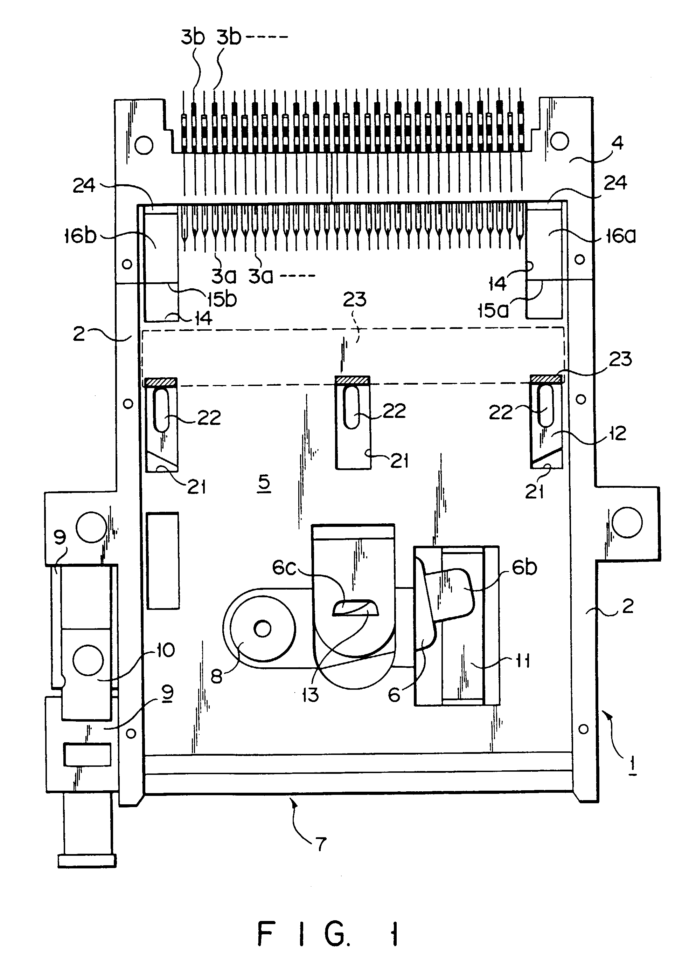

Fig. 1 is a plan view showing a connector apparatus according to one embodiment of the presents invention, the arrangement shown in this Figure normally corresponding to a "circuit board" side in an electronic device for reading data stored in the package.

The connector apparatus 1 comprises a pair of guide frame members 2, made of a resin such as a nylon, spaced apart by a distance somewhat greater than the width of IC package (memory card), not shown. The members 2 each have a length substantially equal to the depth of the package and a thickness substantially equal to the thickness of the package. The members 2 adjoin a connector section 4 having connecting pins 3a for fitting into socket terminals provided on the package and connecting pins 3b at the external side for connection to the device. A housing plate member 5, made of a metal, fixes the guide frame members 2, 2 in place. The guide frame members 2 are secured to the plate 5 with screws 25. The plate 5 has a later-described ejection mechanism formed on its surface, and, upon being mounted in place in the electronic device, defines with the guide frame members 2, a storage space for the package which space has an access hole 7 opposite the connection section 4.

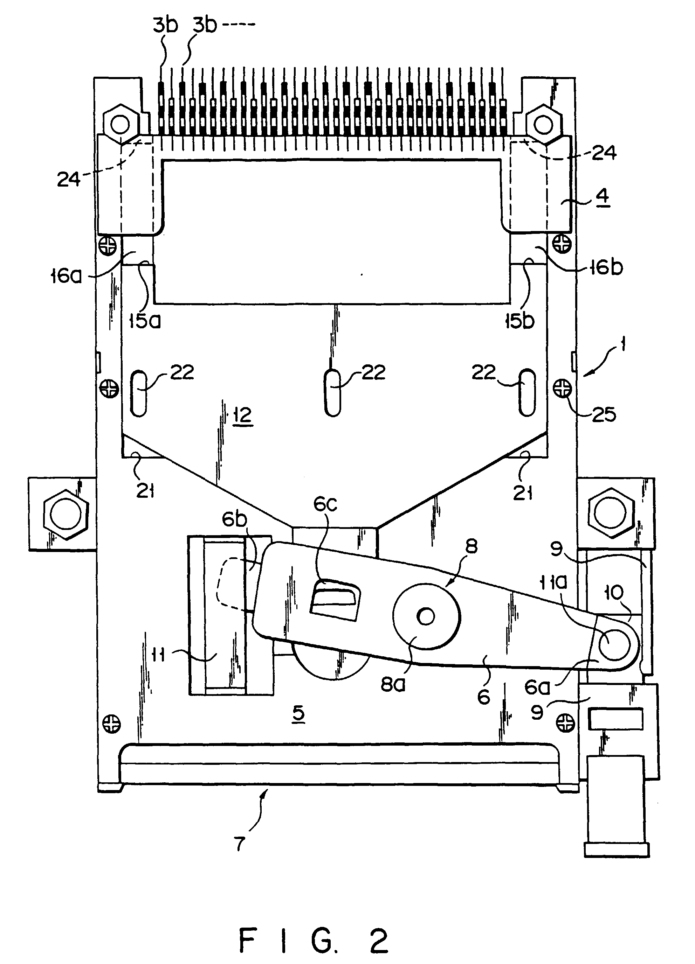

Fig. 2 is a bottom view of the connector apparatus 1 as seen from the rear side as distinct from the side shown in Fig. 1, the ejection mechanism being principally shown in Fig. 2. The ejection mechanism employs an ejection lever or arm 6 made of a metal and supported by a journal or shaft 8 on the lower surface side of the housing plate 5 at an area near the access hole 7 leading to the package storage space. In order to pivot the ejection lever 6 around the journal 8, one end 6a of the ejection lever 6 is pivotably coupled with another journal or shaft lla to one end of a slide member 10 which is slidably movable in a one piece moulded guide 9 at the outer side of one of the guide frame members 2. A tongue 6b is provided integral with the other end of the ejection lever 6. The tongue 6b is located in slidable contact with the inside surface of the band-like guide 11 somewhat raised from the housing plate 5. Thus, the ejection lever 6 is so constructed as to be pivotable in a plane parallel to the housing plate 5. The ejection lever 6 has a raised section 6c projecting toward the housing plate 5.

Reference numeral 12 signifies a pull-out metal conductive plate which can withdraw the package (not shown) out of electrical connection with the connector section 4 of the connector device 1 when the package is not in use. The pull-out plate 12 has a raised engaging claw 13, at its end and is coupled with or engages with the raised section 6c formed on the driven side of the lever 6 as distinct from the drive side 8 of the lever 6. The pull-out metal plate 12 is of such a type that it is slidable in a pull out direction of the package over the housing plate 5 upon pivoting of the ejection lever 6. The pull-out metal plate 12 has extending arms 16a and 16b one at each opposite side. The pull-out metal plate 12 further has bent sections 15a, 15b in a stepped relation such that their forward ends are upwardly projected via cutouts 14, provided at the corresponding areas of the housing plate 5. The forward ends of the arms 16a and 16b are bent to provide engaging hooks 24, 24 engaging with a socket-side end face, that is, the forward end face, of the IC package. Thus the package stored in the storage space of the connector apparatus 1. has its surface placed in direct contact with the arms 16a and 16b of the pull-out plate 12.

The package needs to be electrically shielded and, in order to achieve this, three projections 22 are provided at corresponding places, by an extrusion molding method, in the middle portion of the pull-out metal plate 12 such that they project toward the storage space via through holes 21 provided at the corresponding areas of the housing plate 5 to allow them to contact the outer surface of the inserted IC package.

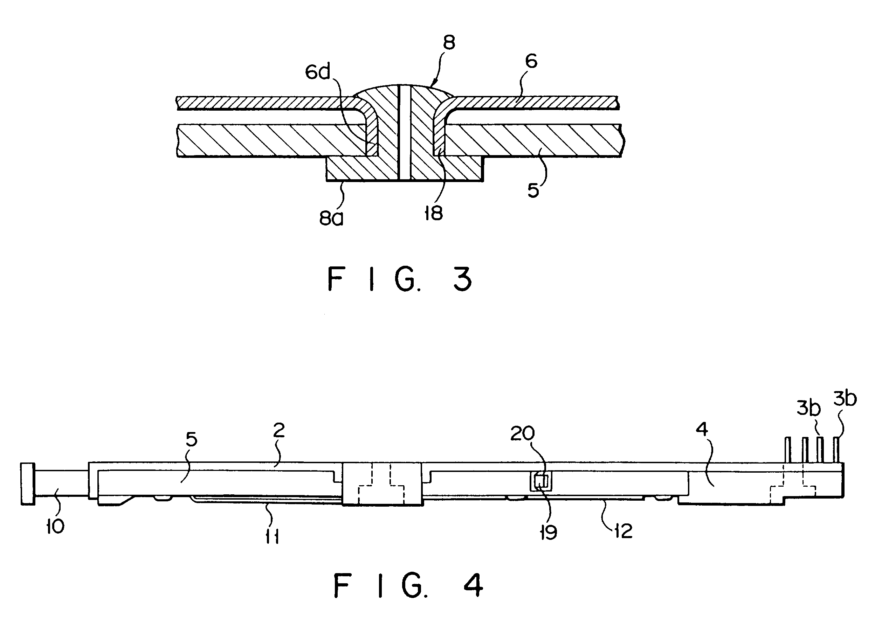

Fig. 3 is a cross-sectional view showing one of the journal support structures of the ejection lever 6. Since the journal support structures for the shafts 8 and 11a are of the same type, only one journal support structure for the shaft 8 will be explained below in conjunction with Fig. 3. As shown in Figure 3, a tubular projection 6d is provided on the ejection lever 6 and is made of, for example, a stainless steel. The tubular projection 6d is fitted in a bearing hole 18 provided in the housing plate 5 and made of, for example, a stainless steel. The shaft 8, made of brass, has a flange 8a at one end and is fitted in a center through hole provided in the tubular projection 6d. The other end of the shaft 8 remote from the flange 8 is caulked-in to prevent the shaft 8 from becoming detached. The projection 6d is rotatable in the bearing hole 18 in accordance with the movement of the lever 6. The ejection lever 6 can be repeatedly pivoted as the IC package is fitted and removed and the outer surface of the tubular projection 6d of the ejection lever 6 makes bearing contact with the inner wall surface of the bearing hole 18 in the housing plate 5. Since the housing plate 5 is made of the same material as that of the ejection lever 6, it is possible to achieve a high wear resistance and hence to achieve a remarkably enhanced endurance at the bearing surfaces.

The problem with the endurance of the bearing has hitherto arisen from, for example, clearance between the shaft and the insertion hole of the ejection lever due to, for example, wear and a resultant reduction in an IC package pullout stroke length. That is a reliability problem has been involved after repeated withdrawal of the package.

It has been found that the aforementioned bearing or journal structure of the ejection lever 6 of the connector apparatus according to the embodiment of the present invention can fully withstand about 20,000 ejection operations, a figure which is generally required in this field of art.

Further, the connector apparatus of the present embodiment is such that the connector section 4 can be separated from the ejection mechanism-equipped housing plate 5 side by a simple operation. Fig. 4 is a side view showing the connector apparatus. In Fig. 4, an engaging arm, not shown, is provided integral with each side section of the connector section 4 made of elastic material and an engaging projection 19 is provided on the forward end of each engaging arm. Each engaging arm of the connector section 4 is inserted into a reception space provided between a bent side portion of the housing plate 5 and a recess formed at the side surface of the associated guide frame member 2. The engaging projection 19 of each arm is fitted into a hole 20 provided in the associated bent side portion of the housing plate 5. Thus, the connector section 4 can be freely and readily attached to, or detached from, the rest of the apparatus by bringing the engaging projections 19 of the engaging arms of the connector section 4 into and out of engagement with the engaging holes 20.

When the package is mounted in the apparatus according to the present invention, it is inserted into the storage space via the access hole 7 of the connector apparatus 1 to fit the socket terminals of the package over the pins 3a of the connector section 4. At this time, the forward end face of the package engages with the engaging hooks 24, 24 of the pull-out metal plate 12 to move the metal plate 12 in a forward direction. As a result, the ejection lever 6 is pivoted around the axis of the journal 8, causing the slider member 10 to be displaced.

With the package held in the storage space, the IC package is grounded through the pull-out plate 12 whose projections 22 are connected via the through holes 21 of the housing plate 5 to the package surface and then through the ejection lever 6, the housing plate 5 and screws 25.

By so doing, it is only necessary that only one surface of the package, that is, only its surface facing the housing plate 5, make electrical contact with the projections 22 of the pull-out plate 12. Therefore, no particular consideration needs to be paid to the other surface of the package which faces the circuit board. It is thus possible to provide a desired printed circuit pattern, for example, on that surface.

Further, since there is no intervening object between the circuit board and the one surface of the package, electric contact can be made between the side of the package and the circuit board and this can be so done at any proper position with the use of a thin metal plate of, for example, a predetermined electric conductivity. It is possible to properly print a desired circuit pattern on each side of the package.

When the package is to be withdrawn out of the storage space, the slider member 10 is pushed, causing the ejection lever 6 to be pivoted around the rotating axis of the journal 8. This action causes the pull-out plate 12 to be moved over the surface of the housing plate 5 along the guide frame members 22 with the raised section 6c hooked by the engaging claw 13, so that the package is withdrawn out of the storage space through the utilization of the engaging hooks 24, 24 on the forward end of the arms 16a, 16b.

In the aforementioned connector apparatus 1, the pull-out plate 12 is freely moved over the surface of the housing plate 5 and, if a deburring process which should be done, for example, at the edge of the punched through hole 21 of the housing plate 5 is omitted so as to lower the manufacturing cost, then there is a possibility that the contacting surface of the draw-out plate 12 will be scraped by the burr. It is preferable that, in order to prevent the occurrence of electrical faults resulting from the drop of the metal scrapings onto the package or connector section, a plate-like covering 23 made of, for example, polyethylene be joined to that area of the pull-out plate 12 where the draw-out plate 12 is moved over the through holes of the housing plate 5.

The connector apparatus according to the present embodiment has a dimension, that is, a thickness about 1.4 times that (about 3 mm) of the package, a width corresponding to a total of the width of the package plus that of the guide frame member 2, and a depth greater than the depth of both the depth of the package and thickness of the engaging hook 24 involved upon engagement of the engaging hooks 24 with the socket-side end face of the package. It is thus possible to obtain a thin compact unit.

As will be evident from the above, the connector apparatus of the present invention can be achieved with much less number of component parts than a conventional connector apparatus for IC package of the same type. It is thus possible to make the whole outer dimension of the connector apparatus closely equal to that of the package per se and hence to provide a thin, durable compact connector apparatus.

## Claims

1. A connector apparatus for use with plate-like IC packages, said apparatus comprising:
a pair of guide frame members (2) spaced apart so as to be suitable to guide a plate-like IC package;
a housing plate member (5) fixing said guide frame members in place;
a connector section (4) having connecting pins (3a) to be electrically connected to said package, provided at one end of the guide frame members (2);
a pull-out plate member (12) displaceable over a surface of the housing plate member (5) and having engaging hooks (24) engageable with a forward end of said package electrically connected to the connector section (4) and
an ejection lever (6) pivotably mounted to the housing plate member (5) with a journal structure and coupled to the pull-out plate (12), the lever (6) being operable to cause the pull-out plate member (12) to be displaced to eject the package; characterized in that the journal structure is composed of a shaft (8) fitted inside a tubular projection (6d) formed as part of said ejection lever (6) or of said housing plate member (5) respectively, the projection (6d) being inserted through a bearing hole (18) formed in said housing plate member (5), or said ejection lever (6) respectively and slippage preventing means provided at each end of the shaft to maintain the lever (6) on the housing plate member (5).

2. The connector apparatus according to claim 1 wherein the tubular projection (6d) is formed on the ejection lever (6) and the bearing hole (18) is formed in the housing plate member (5).

3. The connector apparatus according to claim 1 or 2 wherein the projection (6d) and a surface of the bearing hole (18) are made from a stainless steel and the shaft (8) is made of brass.

4. The connector apparatus according to any one of claims 1 to 3 wherein an actuator in the form of a slide member (10) is slidably movable in a guide (9) at the outer side of one of the guide frame members (2) and the slide member (10) is pivotably coupled with another journal structure (11a) to one end (6a) of the ejection lever (6) so that movement of the slide member 910) effects pivoting of the lever (6).

5. The connector apparatus according to claim 4, wherein the other journal structure (11a) pivotably coupling the lever (6) to the slide member (10) is formed in a similar manner to said journal structure pivotably mounting the lever (6) to the housing plate member (5).

6. The connector apparatus according to claim 4 or 5, wherein the lever (6) has a tongue (6b) at the other end which locates in slidable contact with a guide (11) on the housing plate member (5).

7. The connector apparatus according to any one of claims 1 to 6, wherein the lever (6) is coupled to the pull-out plate (12) with the aid of a raised section (6c) on the lever (6) engaging with a raised claw (1) of the pull-out plate (12).

8. The connector apparatus according to any one of the preceding claims, wherein the pull-out plate (12) has projections (22) which engage through holes (21) in the housing plate (5) to contact the package and provide electrical shielding.

9. A connector apparatus according to any one of the preceding claims wherein the connector section (4) is detachably connected to the structure composed of the guide members (21) and the housing plate member (5).

10. A connector apparatus according to claim 9 wherein the connector section (4) has arms at its sides made of elastic material which engage between bent side portions of the housing plate member (5) and recesses in the guide members (2) and each arm has a projection (19) which fits into a hole (2) in the associated side portion of the plate member (5).

11. A connector apparatus according to any one of the precedings claims , wherein a plate like insulated covering (23) is disposed between the pull-out plate (12) and the housing plate (5).

12. The connector apparatus according to any one of the preceding claims wherein the guide frame members (2) are made of a resin; the housing plate member (5), the pull-out plate member (12) and the ejection lever (6) are made of a metal and the housing plate member (5) and ejection lever (6) are made of the same type of the metal.

13. The connector apparatus according to any one of the preceding claims wherein the guide frame members (2) are fixed to the housing plate member (5) by means of screws (25).

14. The connector apparatus according to any one of the preceding claims , wherein the thickness of the apparatus is about 1.4 times that of the package and the width of the apparatus corresponds to the width of the package and the width of the guide members (2).

15. A connector apparatus according to any one of the preceding claims wherein the whole outer dimension of the apparatus is closely equal to that of the IC package.

## Patentansprüche

1. Steckverbindervorrichtung zur Verwendung mit plattenartigen IC-Bauelementen, wobei die Vorrichtung umfaßt:
- ein Paar von Führungsrahmenelementen (2), die im Abstand voneinander angeordnet sind, so daß sie zur Führung eines plattenartigen IC-Bauelements geeignet sind,
- ein Gehäuseplattenelement (5), das die Führungsrahmenelemente am Ort fixiert,
- einen an einem Ende der Führungsrahmenelemente (2) vorgesehenen Steckerteil (4) mit elektrisch mit dem Bauelement zu verbindenden Steckverbindungsstiften (3a),
- ein über eine Fläche des Gehäuseplattenelements (5) hinweg verlagerbares Ausziehplattenelement (12) mit Eingriffshaken (24), die mit einem vorderen Ende des elektrisch mit dem Steckerteil (4) verbundenen Bauelements in Eingriff bringbar sind, und
- einen Auswurfhebel (6), der mit einer Gelenkkonstruktion schwenkbar an dem Gehäuseplattenelement (5) angebracht ist und mit der Ausziehplatte (12) gekoppelt ist, wobei der Hebel (6) betätigbar ist, um die Verlagerung des Ausziehplattenelements (12) zum Auswurf des Bauelements zu bewirken,
dadurch gekennzeichnet, daß sich die Gelenkkonstruktion zusammensetzt aus einem Schaft (8), der in einen als Teil des Auswurfhebels (6) oder des Gehäuseplattenelements (5) ausgebildeten rohrförmigen Vorsprung (6d) eingesetzt ist, wobei der Vorsprung (6d) durch ein in dem Gehäuseplattenelement (5) bzw. dem Auswurfhebel (6) ausgebildetes Lagerloch (18) eingesetzt ist, und aus Rutschverhinderungsmitteln, die an jedem Ende des Schafts vorgesehen sind, um den Hebel (6) an dem Gehäuseplattenelement (5) zu halten.

2. Steckverbindervorrichtung nach Anspruch 1, bei der der rohrförmige Vorsprung (6d) an dem Auswurfhebel (6) ausgebildet ist und das Lagerloch (18) in dem Gehäuseplattenelement (5) gebildet ist.

3. Steckverbindervorrichtung nach Anspruch 1 oder 2, bei der der Vorsprung (6d) und eine Oberfläche des Lagerlochs (18) aus rostfreiem Stahl gefertigt sind und der Schaft (8) aus Messing gefertigt ist.

4. Steckverbindervorrichtung nach einem der Ansprüche 1 bis 3, bei der ein Aktuator in Form eines Schiebeelements (10) verschiebbar in einer Führung (9) an der Außenseite eines der Führungsrahmenelemente (2) beweglich ist und das Schiebeelement (10) mit einer weiteren Gelenkkonstruktion (11a) schwenkbar mit einem Ende (6a) des Auswurfhebels (6) gekoppelt ist, so daß eine Bewegung des Schiebeelements (10) eine Verschwenkung des Hebels (6) bewirkt.

5. Steckverbindervorrichtung nach Anspruch 4, bei der die den Hebel (6) schwenkbar mit dem Schiebeelement (10) koppelnde weitere Gelenkkonstruktion (11a) in ähnlicher Weise wie die den Hebel (6) schwenkbar an dem Gehäuseplattenelement (5) anbringende Gelenkkonstruktion ausgebildet ist.

6. Steckverbindervorrichtung nach Anspruch 4 oder 5, bei der der Hebel (6) am anderen Ende eine Zunge (6b) aufweist, welche in Schiebekontakt mit einer Führung (11) an dem Gehäuseplattenelement (5) steht.

7. Steckverbindervorrichtung nach einem der Ansprüche 1 bis 6, bei der der Hebel (6) mit Hilfe eines in Eingriff mit einer erhöhten Klaue (1) der Ausziehplatte (12) stehenden erhöhten Abschnitts (6c) an dem Hebel (6) mit der Ausziehplatte (12) gekoppelt ist.

8. Steckverbindervorrichtung nach einem der vorhergehenden Ansprüche, bei der die Ausziehplatte (12) Vorsprünge (22) aufweist, welche in Durchgangslöcher (21) in der Gehäuseplatte (5) eingreifen, um das Bauelement zu kontaktieren und eine elektrische Abschirmung vorzusehen.

9. Steckverbindervorrichtung nach einem der vorhergehenden Ansprüche, bei der der Steckerteil (4) lösbar mit der sich aus den Führungselementen (21) und dem Gehäuseplattenelement (5) zusammensetzenden Struktur verbunden ist.

10. Steckverbindervorrichtung nach Anspruch 9, bei der der Steckerteil (4) an seinen Seiten aus elastischem Material gefertigte Arme aufweist, welche zwischen gebogene Seitenabschnitte des Gehäuseplattenelements (5) und Ausnehmungen in den Führungselementen (2) eingreifen, und bei der jeder Arm einen Vorsprung (19) aufweist, welcher in ein Loch (2) in dem zugehörigen Seitenabschnitt des Plattenelements (5) paßt.

11. Steckverbindervorrichtung nach einem der vorhergehenden Ansprüche, bei der ein plattenartiger Isolierüberzug (23) zwischen der Ausziehplatte (12) und der Gehäuseplatte (5) angeordnet ist.

12. Steckverbindervorrichtung nach einem der vorhergehenden Ansprüche, bei der die Führungsrahmenelemente (2) aus einem Harz gefertigt sind, das Gehäuseplattenelement (5), das Ausziehplattenelement (12) und der Auswurfhebel (6) aus einem Metall gefertigt sind und das Gehäuseplattenelement (5) und der Auswurfhebel (6) aus der gleichen Art von Metall gefertigt sind.

13. Steckverbindervorrichtung nach einem der vorhergehenden Ansprüche, bei der die Führungsrahmenelemente (2) mittels Schrauben (25) an dem Gehäuseplattenelement (5) befestigt sind.

14. Steckverbindervorrichtung nach einem der vorhergehenden Ansprüche, bei der die Dicke der Vorrichtung etwa 1,4 mal derjenigen des Bauelements ist und die Breite der Vorrichtung der Breite des Bauelements und der Breite der Führungselemente (2) entspricht.

15. Steckverbindervorrichtung nach einem der vorhergehenden Ansprüche, bei der das gesamte Außenmaß der Vorrichtung annähernd gleich dem des IC-Bauelements ist.

## Revendications

1. Appareil connecteur à utiliser avec des encapsulages de circuits intégrés en forme de plaquettes, ledit appareil comprenant :
une paire d'éléments de structure de guidage (2) placés à distance l'un de l'autre de façon à être appropriés pour guider un encapsulage de circuits intégrés en forme de plaquettes ;
un élément de plaque de logement (5) fixant en place lesdits éléments de structure de guidage ;
une section de connecteur (4) comportant des broches de connexion (3a) afin d'être connectée électriquement audit encapsulage prévue au niveau d'une extrémité des éléments de structure de guidage (2) ;
un élément de plaque de déconnexion (12) pouvant être déplacé sur une surface de l'élément de plaque de logement (5) et comportant des crochets d'engagement (24) pouvant coopérer avec une extrémité avant dudit encapsulage connecté électriquement à la section de connecteur (4) et
un levier d'éjection (6) monté de façon à pouvoir pivoter sur l'élément de la plaque de logement (5) avec une structure de tourillon et couplé à la plaque de déconnexion (12), le levier (6) pouvant être actionné pour entrainer l'élément de plaque de déconnexion (12) à se déplacer pour éjecter l'encapsulage ; caractérisé en ce que la structure de tourillon est composée d'un arbre (8) ajusté à l'intérieur d'une partie tubulaire en saillie (6d) faisant partie dudit levier d'éjection (6) ou dudit élément de plaque de logement (5), respectivement, la partie en saillie (6d) étant insérée à travers un trou de palier (18) formé dans ledit élément de plaque de logement (5), ou dans ledit levier d'éjection (6), respectivement, et des moyens empêchant le glissement, prévus à chaque extrémité de l'arbre afin de maintenir le levier (6) sur l'élément de plaque de logement (5).

2. Appareil connecteur selon la revendication 1, dans lequel la partie tubulaire en saillie (6d) est formée sur le levier d'éjection (6) et le trou de palier (18) est formé dans l'élément de plaque de logement (5).

3. Appareil connecteur selon la revendication 1 ou 2, dans lequel la partie en saillie (6d) et une surface du trou de palier (18) sont constituées d'acier inoxydable et l'arbre (8) est fait de laiton.

4. Appareil connecteur selon l'une quelconque des revendications 1 à 3, dans lequel un dispositif de commande sous forme d'un élément coulissant (10) peut être déplacé en coulissant dans un guide (9) sur le côté extérieur de l'un des éléments de structure de guidage (2) et l'élément coulissant (10) est couplé de façon à pivoter avec une autre structure de tourillon (lla) à une extrémité (6a) du levier d'éjection (6), de sorte qu'un mouvement de l'élément coulissant (10) effectue le pivotement du levier (6).

5. Appareil connecteur selon la revendication 4, dans lequel l'autre structure de tourillon (lla) couplant de façon à pivoter le levier (6) à l'élément coulissant (10) est formé d'une manière semblable à ladite structure de tourillon montant de façon pivotante le levier (6) sur l'élément de plaque de logement (5).

6. Appareil connecteur selon la revendication 4 ou 5, dans lequel le levier (6) comporte une languette (6b) au niveau de l'autre extrémité , laquelle se place en contact glissant avec un guide (11) sur l'élément de plaque de logement (5).

7. Appareil connecteur selon l'une quelconque des revendication 1 à 6, dans lequel le levier (6) est couplé à la plaque de déconnexion (12) avec l'aide d'une section en relief (6c) située sur le levier (6) coopérant avec une griffe en relief (1) de la plaque de déconnexion (12).

8. Appareil connecteur selon l'une quelconque des revendications précédentes , dans lequel la plaque de déconnexion (12) comporte des parties en saillie (22) qui s'engagent dans des trous de passage (21) situés dans la plaque de logement (5) pour être en contact avec l'encapsulage et fournir une protection électrique.

9. Appareil connecteur selon l'une quelconque des revendications précédentes , dans lequel la section de connecteur (4) peut être connectée de façon amovible à la structure composée des éléments de guidage (21) et de l'élément de plaque de logement (5).

10. Appareil connecteur selon la revendication 9, dans lequel la section de connecteur (4) comporte sur ses côtés des bras constitués d'un matériau élastique qui s'engagent entre des parties latérales courbées de l'élément de plaque de logement (5) et des évidements situés dans les éléments de guidage (2) et chaque bras comporte une partie en saillie (19) qui s'ajuste dans un trou (2) de la partie latérale associée de l'élément de plaque (5).

11. Appareil connecteur selon l'une quelconque des revendications précédentes , dans lequel un couvercle isolant en forme de plaque (23) est disposé entre la plaque de déconnexion (12) et la plaque de logement (5).

12. Appareil connecteur selon l'une quelconque des revendications précédentes dans lequel les éléments de structure de guidage (2) sont faits de résine ; l'élément de plaque de logement (5), l'élément de plaque de déconnexion (12) et le levier d'éjection (6) sont réalisés en métal et l'élément de plaque de logement (5) et le levier d'éjection (6) sont faits du même type de métal.

13. Appareil connecteur selon l'une quelconque des revendications précédentes dans lequel les éléments de structure de guidage (2) sont fixés à l'élément de plaque de logement (5) au moyen de vis (25).

14. Appareil connecteur selon l'une quelconque des revendications précédentes, dans lequel l'épaisseur de l'appareil représente environ 1,4 fois celle de l'encapsulage et la largeur de l'appareil correspond à la largeur de l'encapsulage et à la largeur des éléments de guidage (2).

15. Appareil connecteur selon l'une quelconque des revendications précédentes dans lequel la dimension totale extérieure de l'appareil est pratiquement égale à celle de l'encapsulage de circuits intégrés.
